# EUROPÄISCHE PATENTANMELDUNG

(11) **EP 3 131 371 A2**
(43) Veröffentlichungstag der Anmeldung: **15.02.2017**
(21) Anmeldenummer: 16180076.8
(22) Anmeldetag: 19.07.2016
(51) Int. Cl.: H05K 1/02, H05K 3/00

(54) **RADARSENSOR**

(30) Priorität: 12.08.2015 DE 102015215398
(71) Anmelder: InnoSenT GmbH, 97499 Donnersdorf (DE)
(72) Erfinder: Bäuerlein, Stefan, 97497 Dingolshausen (DE); Lenhard, Thilo, 96103 Hallstadt (DE)
(74) Vertreter: Grauel, Andreas

(57) **Zusammenfassung**

Die Erfindung betrifft einen Radarsensor (1) mit einer Leiterplatte mit einer elektronischen Schaltung und mit einer Bestückung elektronischer Komponenten und mit einem die Leiterplatte und die darauf angeordnete Bestückung abdeckenden Abschirmdeckel (10, 50), wobei der Abschirmdeckel aus einem Leiterplattenmaterial (11, 51) ausgebildet ist und eine Einbuchtung (12, 52) aufweist, welche Raum für die Aufnahme der Bestückung schafft.

## Beschreibung

### Technisches Gebiet

Die Erfindung betrifft einen Radarsensor, wie insbesondere für ein Kraftfahrzeug oder für andere Anwendungen.

### Stand der Technik

Radarsensoren sind insbesondere für Kraftfahrzeuge immer häufiger in Anwendung, um für Fahrerassistenzsysteme Informationen über das Umfeld des Kraftfahrzeugs zu liefern.

Solche Radarsensoren weisen ein Gehäuse mit einer darin angeordneten Leiterplatte mit einer elektronischen Schaltung mit elektronischer Bestückung auf, wobei auch zumindest eine Antenne und Anschlusselemente vorgesehen sind. Dabei wird üblicherweise ein leitfähiger Deckel auf das Gehäuse oder auf die Platine aufgesetzt, damit eine HF-Schirmung und gegebenenfalls eine EMV-Abschirmung erfolgen können.

Dabei sind die Herstellung und die Montage eines solchen leitfähigen Deckels aufwändig und damit kostenträchtig.

### Darstellung der Erfindung, Aufgabe, Lösung, Vorteile

Es ist die Aufgabe der Erfindung, einen Radarsensor zu schaffen, der einfach und kostengünstig aufgebaut ist und dennoch auch einfach zu montieren ist.

Die Aufgabe wird mit den Merkmalen von Anspruch 1 gelöst.

Ein Ausführungsbeispiel der Erfindung betrifft einen Radarsensor mit einer Leiterplatte mit einer elektronischen Schaltung und mit einer Bestückung elektronischer Komponenten und mit einem die Leiterplatte und die darauf angeordnete Bestückung abdeckenden Abschirmdeckel, wobei der Abschirmdeckel aus einem Leiterplattenmaterial ausgebildet ist und eine Einbuchtung aufweist, welche Raum für die Aufnahme der Bestückung schafft. Dadurch kann durch einfache Herstellung ein Abschirmdeckel erzeugt werden, der beispielsweise auch in einem SMD-Verfahren mit der Leiterplatte verbindbar ist und verlötbar ist. Dadurch kann ein höherer Grad der Automatisierung des Herstellprozesses vorgenommen werden, was die Kosten senkt. Dabei ist mit einer Bestückung insbesondere die Bestückung mit elektronischen Komponenten gemeint.

Besonders vorteilhaft ist es, wenn der Abschirmdeckel aus einem einlagigen oder mehrlagigen Leiterplattenmaterial besteht. Dies kann die Stabilität und auch die Abschirmung verbessern, je nachdem, welche Anforderungen an die Abschirmung des Abschirmdeckels gestellt werden, kann so ein ein- oder mehrlagiges Leiterplattenmaterial eingesetzt werden.

Dabei ist es besonders vorteilhaft, wenn das einlagige oder mehrlagige Leiterplattenmaterial eine einlagige oder mehrlagige elektrisch leitende Schicht enthält und zumindest eine einlagige oder mehrlagige nichtleitende Schicht enthält. Dadurch kann aufgrund der einen oder der mehreren elektrisch leitenden Schichten die Abschirmung verbessert werden.

Besonders vorteilhaft ist es, wenn die Einbuchtung eine Freisparung ist, die in das Material der Leiterplatte insbesondere durch Fräsen eingebracht ist. Dadurch kann aus einer ebenen Leiterplatte ein Deckel mit Einbuchtung erzeugt werden, so dass das Grundmaterial der Leiterplatte als Massenware kostengünstig bezogen werden kann.

Auch ist es vorteilhaft, wenn der Abschirmdeckel elektrisch leitende Kontaktplätze aufweist, welche zum lösenden Verbinden des Abschirmdeckels mit der Leiterplatte und/oder mit anderweitigen Komponenten und/oder Platinen aufweist. Dadurch kann der Abschirmdeckel einfach mit anderen Elementen verlötet werden, ohne dass zusätzliche Maßnahmen oder Verbindungselemente notwendig werden.

Auch ist es vorteilhaft, wenn der Abschirmdeckel auf seiner Innenseite und/oder auf seiner Außenseite einseitig oder beidseitig Kontaktplätze aufweist. Dadurch können einfach Verbindungen zu anderen Elementen erreicht werden.

Auch ist es vorteilhaft, wenn der Abschirmdeckel zumindest eine elektrische leitende Kontaktierung zwischen Kontaktplätzen auf der Innenseite und auf der Außenseite aufweist. Das kann auch durch eine Durchkontaktierung erreicht werden, wenn auf der Innenseite eine elektrische Verbindung erzeugt wird, an welche man dann von außen ein Element kontaktieren kann.

Auch ist es vorteilhaft, wenn die zumindest eine elektrische leitende Kontaktierung zwischen Kontaktplätzen auf der Innenseite und auf der Außenseite entlang des umlaufenden Randes des Abschirmdeckels verläuft. So können einfach von außen Kontaktierungen nach innen erzeugt und angeschlossen werden, wie beispielsweise mittels SMD-Technologie.

Auch ist es vorteilhaft, wenn entlang des umlaufenden Randes des Abschirmdeckels elektrisch leitende Kontaktplätze vorgesehen sind.

Dabei ist es auch vorteilhaft, wenn der Abschirmdeckel auf seiner Innenseite der Einbuchtung mit einer metallisiert Schicht versehen ist. Dies verbessert die Abschirmeigenschaften.

Weitere vorteilhafte Ausgestaltungen sind durch die nachfolgende Figurenbeschreibung und durch die Unteransprüche beschrieben.

### Kurze Beschreibung der Zeichnungen

Nachstehend wird die Erfindung auf der Grundlage zumindest eines Ausführungsbeispiels anhand der Zeichnungen näher erläutert. Es zeigen:
- Fig. 1: eine schematische Ansicht eines Radarsensors nach dem Stand der Technik,
- Fig. 2: eine schematische Darstellung einer Seite eines Abschirmdeckels,
- Fig. 3: eine schematische Darstellung der anderen Seite des Abschirmdeckel nach Figur 2,
- Fig. 4: eine schematische Darstellung einer Seite eines weiteren Abschirmdeckels, und
- Fig. 5: eine schematische Darstellung der anderen Seite des Abschirmdeckels nach Figur 4.

### Bevorzugte Ausführung der Erfindung

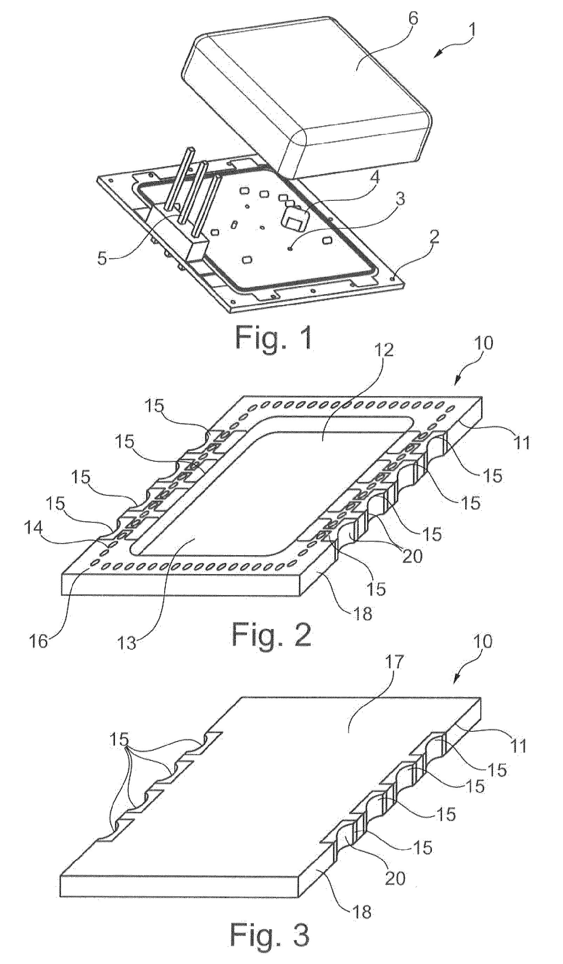

Die Figur 1 zeigt einen Radarsensor 1 nach dem Stand der Technik. Der Radarsensor 1 ist mit einer HF-Leiterplatte 2 mit einer elektronischen Schaltung 3 und mit einer Bestückung elektronischer Komponenten 4 versehen. Dabei sind beispielsweise auch Anschlusspins 5 vorgesehen, welche mit der Leiterplatte 2 verbunden sind. Weiterhin ist ein die Leiterplatte 2 und die darauf angeordnete Bestückung abdeckender Abschirmdeckel 6 vorgesehen, welcher mit der Leiterplatte 2 zu verbinden ist.

Der Abschirmdeckel 6 ist als einseitig offener Hohlkörper ausgebildet, der elektrisch leitend ist. Dieser Abschirmdeckel 6 ist mit der Leiterplatte 2 zu verbinden, was ein komplexer und damit auch teurer Montagevorgang ist.

Die Figuren 2 und 3 zeigen einen erfindungsgemäßen Abschirmdeckel 10, der aus einem Leiterplattenmaterial 11 ausgebildet ist und eine Einbuchtung 12 aufweist, welcher die Bestückung der Leiterplatte aufnehmen kann. Die Rückseite des Abschirmdeckels ist in Figur 3 gezeigt. Diese ist im Wesentlichen eben ausgebildet. Die Einbuchtung 12 ist dabei eine Freisparung, die in das Material 11 der Leiterplatte insbesondere durch Fräsen, wie Tieffräsen, eingebracht ist. Dadurch wird eine Art beckenförmiges Volumen in der Leiterplatte des Abschirmdeckels 10 erzeugt, das von einem Boden 13 und einer umlaufenden Wand 14 gebildet ist.

Gemäß der Erfindung ist es vorteilhaft, wenn der Abschirmdeckels 10 aus einem einlagigen oder mehrlagigen Leiterplattenmaterial 11 besteht. Dabei kann das einlagige oder mehrlagige Leiterplattenmaterial 11 eine einlagige oder mehrlagige elektrisch leitende Schicht enthalten und zumindest eine einlagige oder mehrlagige nichtleitende Schicht enthalten.

Zur Verbindung des Abschirmdeckels 10 beispielsweise mit einer Leiterplatte sind elektrisch leitende Kontaktplätze 15 vorgesehen, welche zum lötenden Verbinden des Abschirmdeckels 10 mit der Leiterplatte und/oder mit anderweitigen Komponenten und/oder Platinen aufweist. Die Figuren 2 und 3 zeigen, dass der Abschirmdeckel 10 auf seiner Innenseite 16 und/oder auf seiner Außenseite 17 einseitig oder beidseitig Kontaktplätze 15 aufweist.

Dabei sind die Kontaktplätze metallische Flächenelemente, die dem Verlöten oder elektrisch leitfähigen Verkleben dienen.

Diese Kontaktplätze 15 können dabei so ausgebildet sein, dass sie sich über den Rand 18 des Abschirmdeckels 10 erstrecken. Der Abschirmdeckel 10 weist dabei vorteilhaft und optional zumindest eine elektrische leitende Kontaktierung 20 zwischen Kontaktplätzen 15 auf der Innenseite 16 und auf der Außenseite 17 auf. Dabei ist in den Figuren 2 und 3 zu erkennen, dass die zumindest eine elektrische leitende Kontaktierung 20 zwischen Kontaktplätzen 15 auf der Innenseite 16 und auf der Außenseite 17 entlang des umlaufenden Randes 18 des Abschirmdeckels 10 verläuft.

Die elektrisch leitenden Kontaktierungen 20, die entlang des umlaufenden Randes 18 des Abschirmdeckels 10 angeordnet sind, können auch als elektrisch leitende Kontaktplätze vorgesehen sein.

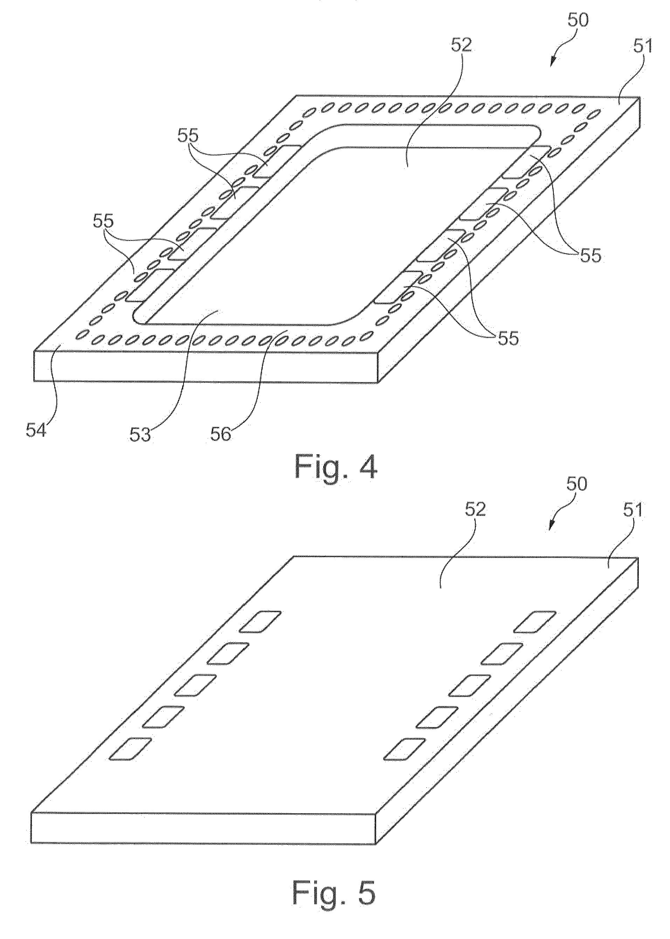

Die Figuren 4 und 5 zeigen einen weiteren erfindungsgemäßen Abschirmdeckel 50, der aus einem Leiterplattenmaterial 51 ausgebildet ist und eine Einbuchtung 52 aufweist, welcher die Bestückung der Leiterplatte aufnehmen kann. Die Rückseite des Abschirmdeckels ist in Figur 5 gezeigt. Diese ist im Wesentlichen eben ausgebildet. Die Einbuchtung 52 ist dabei eine Freisparung, die in das Material 51 der Leiterplatte insbesondere durch Fräsen, wie Tieffräsen, eingebracht ist. Dadurch wird eine Art beckenförmiges Volumen in der Leiterplatte des Abschirmdeckels 50 erzeugt, das von einem Boden 53 und einer umlaufenden Wand 54 gebildet ist.

Gemäß der Erfindung ist es vorteilhaft, wenn der Abschirmdeckel 50 aus einem einlagigen oder mehrlagigen Leiterplattenmaterial 51 besteht. Dabei kann das einlagige oder mehrlagige Leiterplattenmaterial 51 eine einlagige oder mehrlagige elektrisch leitende Schicht enthalten und zumindest eine einlagige oder mehrlagige nichtleitende Schicht enthalten.

Zur Verbindung des Abschirmdeckels 50 beispielsweise mit einer Leiterplatte sind elektrisch leitende Kontaktplätze 55 vorgesehen, welche zum lötenden Verbinden des Abschirmdeckels 50 mit der Leiterplatte und/oder mit anderweitigen Komponenten und/oder Platinen aufweist. Die Figuren 4 und 5 zeigen, dass der Abschirmdeckel 50 auf seiner Innenseite 56 und/oder auf seiner Außenseite 57 einseitig oder mehrseitig oder gegebenenfalls beidseitig Kontaktplätze 55 aufweist. Dabei sind die Kontaktplätze metallische Flächenelemente, die dem Verlöten dienen.

Neben den metallischen Schichten des Leiterplattenmaterials 11, 51 kann alternativ oder optional zusätzlich der Abschirmdeckel 10, 50 auch auf seiner Innenseite der Einbuchtung 12, 52 mit einer metallisiert Schicht versehen sein.

## Patentansprüche

1. Radarsensor mit einer Leiterplatte mit einer elektronischen Schaltung und mit einer Bestückung elektronischer Komponenten und mit einem die Leiterplatte und die darauf angeordnete Bestückung abdeckenden Abschirmdeckel, **dadurch gekennzeichnet, dass** der Abschirmdeckel aus einem Leiterplattenmaterial ausgebildet ist und eine Einbuchtung aufweist, welche Raum für die Aufnahme der Bestückung schafft.

2. Radarsensor nach Anspruch 1, **dadurch gekennzeichnet, dass** der Abschirmdeckel aus einem einlagigen oder mehrlagigen Leiterplattenmaterial besteht.

3. Radarsensor nach Anspruch 2, **dadurch gekennzeichnet, dass** das einlagige oder mehrlagige Leiterplattenmaterial eine einlagige oder mehrlagige elektrisch leitende Schicht enthält und zumindest eine einlagige oder mehrlagige nichtleitende Schicht enthält.

4. Radarsensor nach einem der Ansprüche 1, 2 oder 3, **dadurch gekennzeichnet, dass** die Einbuchtung eine Freisparung ist, die in das Material der Leiterplatte insbesondere durch Fräsen eingebracht ist.

5. Radarsensor nach einem der vorhergehenden Ansprüche, **dadurch gekennzeichnet, dass** der Abschirmdeckel elektrisch leitende Kontaktplätze aufweist, welche zum lötenden Verbinden des Abschirmdeckels mit der Leiterplatte und/oder mit anderweitigen Komponenten und/oder Platinen aufweist.

6. Radarsensor nach Anspruch 5, **dadurch gekennzeichnet, dass** der Abschirmdeckel auf seiner Innenseite und/oder auf seiner Außenseite einseitig oder mehrseitig Kontaktplätze aufweist.

7. Radarsensor nach Anspruch 5 oder 6, **dadurch gekennzeichnet, dass** der Abschirmdeckel zumindest eine elektrische leitende Kontaktierung zwischen Kontaktplätzen auf der Innenseite und auf der Außenseite aufweist.

8. Radarsensor nach einem der vorhergehenden Ansprüche, **dadurch gekennzeichnet, dass** die zumindest eine elektrische leitende Kontaktierung zwischen Kontaktplätzen auf der Innenseite und auf der Außenseite entlang des umlaufenden Randes des Abschirmdeckels, verläuft.

9. Radarsensor nach einem der vorhergehenden Ansprüche, **dadurch gekennzeichnet, dass** entlang des umlaufenden Randes des Abschirmdeckels elektrisch leitende Kontaktplätze vorgesehen sind.

10. Radarsensor nach einem der vorhergehenden Ansprüche, **dadurch gekennzeichnet, dass** der Abschirmdeckel auf seiner Innenseite der Einbuchtung mit einer metallisiert Schicht versehen ist.
